# EUROPEAN PATENT SPECIFICATION

(11) **EP 1 603 239 B1**
(45) Date of publication and mention of the grant of the patent: **24.10.2012**
(21) Application number: 05011771.2
(22) Date of filing: 01.06.2005
(51) Int. Cl.: H03K 19/003

(54) **A voltage tolerant input protection circuit for buffer**
Spannungstolerante Eingangsschutzschaltung für Puffer
Circuit de protection d'entrée tolérant à la tension pour circuit tampon

(30) Priority: 02.06.2004 IN De10092004; 21.10.2004 IN De10092004
(43) Date of publication of application: 07.12.2005
(73) Proprietor: STMicroelectronics Pvt. Ltd, Noida-201 301, Uttar Pradesh (IN)
(72) Inventor: Gupta, Nitin, Noida - 201 301 (IN)
(74) Representative: Ferrari, Barbara

(56) References cited:
- US-A1- 2002 067 185
- US-B1- 6 670 840

## Description

### Field of the Invention

The present invention in general relates to a voltage tolerant input protection circuits, and particularly to voltage tolerant protection circuit for input buffer.

### Background of the Invention

The significance of voltage protection circuit for input buffer is discussed with reference to a differential receiver circuit. Herein, the voltage protection circuit is a circuit between the I/O pad of an integrated circuit and a differential receiver, said protection circuit producing a signal that is used as attenuation free input signal for the differential receiver circuit. For a differential receiver operating on 3.3V technology having common mode input range equal to 0.8V to 2.5V and having differential input sensitivity equal to 200mV, it is essential that both the inputs of differential receiver are free of any amplitude attenuation in common mode input range. To make the differential receiver five-volt tolerant, input voltage shall be equal to supply voltage whenever the input voltage crosses the supply voltage.

Conventionally, NMOS transistors are used in voltage tolerant protection circuits, wherein the gate of the NMOS transistor is connected to the supply voltage, source is connected to the Pad and drain is connected to the Input Buffer. If the voltage at Pad is less than or equal to VDD-Vt (NMOS Threshold), signal at the input buffer follows the Pad voltage without any amplitude attenuation. When Pad voltage is higher than the NMOS threshold then the signal at input buffer is attenuated at NMOS threshold. For minimum allowed supply voltage, the signal at input buffer goes beyond NMOS threshold and for large common mode input range the value of NMOS threshold may lie between the common mode input range, thus resulting in signal degradation. Further, delay is introduced on the rising edge of the signal at input buffer for high frequency operation of said input buffer.

Figure 1 illustrates a prior art voltage protection circuit as per US Patent Application 2004/0007712 A1. Here NMOS transistors are used for protection. As per the given circuit, VOUT follows the Pad voltage from 0V to VDD-vt (PMOS threshold), and supply voltage (VDD) is outputted at VOUT whenever input voltage crosses the PMOS threshold. There is static consumption on the supply voltage through transistors 224 & 226 when Pad voltage is less than VDD-vt (PMOS threshold) and it is undesirable to have a direct path between power supply and ground in normal operating condition. When Pad voltage is greater than VDD-vt (PMOS threshold), and 3.3V transistors are used in the protection circuit, there can be electrical stress on PMOS 234. Electrical stress on the transistors in the protection circuit is undesirable that results in the output signal attenuation. Moreover, the US patent application published under No. US 2002/0067185 describes an interface circuit employing high voltage tolerant extended drain devices.

Thus, a need is felt for a voltage tolerant protection circuit for input buffer that prevents stress on transistors, minimizes power supply consumption and transfers signals without any change in the amplitude.

### Object and summary of the Invention

The object of the present invention is to provide an improved voltage tolerant protection circuit for input buffer.

It is another object of the present invention provide a voltage tolerant protection circuit showing a zero power consumption on pad in normal operating conditions, and minimum power consumption when pad is operating at a higher voltage.

It is yet another object of the present invention is to provide attenuation free signal up to the supply voltage for the input buffer.

Further object of the present invention is to avoid stress on the transistors in the protection circuit.

To achieve said objectives the instant invention provides an improved voltage tolerant protection circuit for input buffer comprising:
- a transmission gate circuit receiving an input voltage from a pad,
- a control signal generator connected between said transmission gate circuit and the pad to provide a control signal for operating said transmission gate circuit, and
- an N-Well generation circuit connected between the pad and said transmission gate circuit, and also connected to said control signal generator for generating a bias signal for said transmission gate circuit and said control signal generator.

According to the invention, the transmission gate circuit comprises:
- a first transistor receiving said control signal from said control signal generator and said bias signal from said N-Well generation circuit to transfer the pad voltage from threshold voltage to a supply voltage;
- a second transistor connected to said first transistor and receiving the supply voltage and a reference voltage, such as a ground voltage, as control signals to form a closed path when the pad voltage is higher than the supply voltage;
- a third transistor connected to said first and second transistors for providing an output equal to the supply voltage when the pad voltage crosses the supply voltage.

In particular, the first transistor is a PMOS transistor and the second and third transistors are NMOS transistors.

Advantageously according to the invention, the control signal generator comprises:
- a first PMOS transistor connected to the pad and receiving control signals from the supply voltage and said N-Well generation block for avoiding consumption on the pad;
- a second NMOS transistor connected to said first PMOS transistor receiving control signals from supply voltage and ground for transferring a potential when pad voltage is less than supply voltage;
- a third NMOS transistor connected to said second NMOS transistor and receiving control signals for transferring a potential to the source of said second NMOS transistor when pad voltage is less than or equal to the PMOS threshold and to form an open circuit path when the pad voltage is greater than the PMOS threshold;
- a fourth PMOS transistor connected to the pad and receiving said bias signal and supply voltage for providing a closed path for conduction when pad voltage is greater than the PMOS threshold;
- a fifth NMOS transistor connected to said fourth PMOS transistor and receiving control signals from supply voltage and ground to provide controlled voltage response when the pad voltage is greater than the supply voltage;
- a sixth NMOS transistor connected to said fifth NMOS transistor for providing a controlled potential at the source of said fifth NMOS transistor;
- a seventh NMOS transistor connected to said sixth NMOS transistor for providing a controlled closed circuit path;
- an eighth NMOS transistor and a ninth NMOS transistor connected to said sixth NMOS transistor for outputting NMOS threshold potential when pad voltage is less than or equal to supply voltage;
- a tenth PMOS transistor and an eleventh NMOS transistor connected to said sixth and seventh NMOS transistors and to said eighth NMOS transistor for providing a true value of the supply voltage to said third NMOS transistor.

In particular, the sixth and seventh NMOS transistors are connected in series.

Also, the drain terminals of said eighth and ninth NMOS transistors are connected to their respective gate terminals, and source of said eighth NMOS transistor is connected to drain of said ninth NMOS transistor.

Furthermore, the tenth PMOS transistor and said eleventh NMOS transistor are connected to each other to form an inverter circuit.

The present invention also provides a method for protecting an input buffer circuit comprising steps of:
- transferring signal from a pad to an input buffer through a transmission gate circuit;
- providing a control signal to said transmission gate circuit by a control signal generator, said control signal being zero volt when a pad voltage is less than or equal to a supply voltage, and being of same value as the pad voltage when the pad voltage is higher than the supply voltage, thereby avoiding electrical stress on the transistors; and
- providing a bias signal for said control signal generator and transmission gate circuit, said bias signal being equal to the supply voltage when the pad voltage is less than the supply voltage and equal to a threshold potential when the pad voltage is greater than the supply voltage.

### Brief Description of the Accompanying Drawings

The invention will now be described with reference to the accompanying drawings.

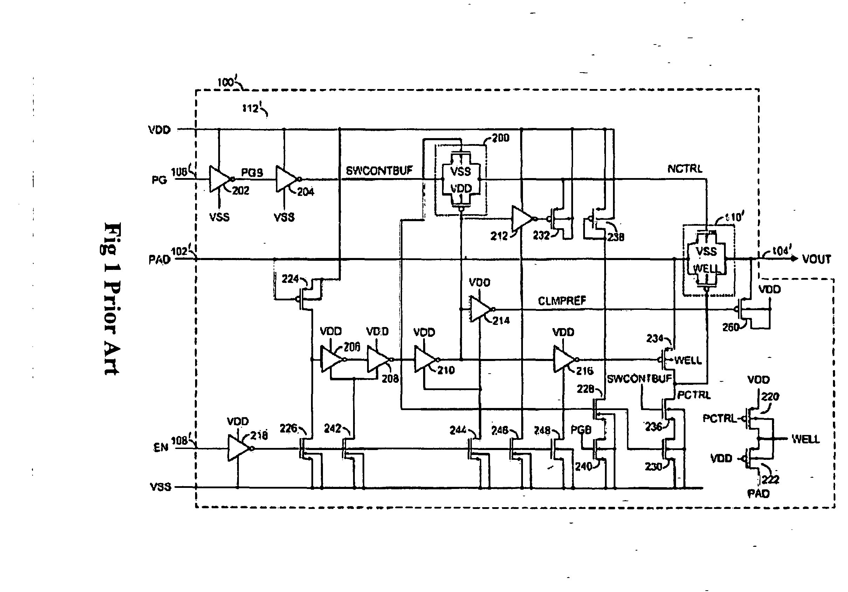

**Figure 1** schematically shows a voltage protection circuit in accordance with the prior art.
**Figure 2** schematically shows a voltage tolerant protection circuit for input buffer in accordance with the present invention.
**Figure 3** schematically shows a transmission gate circuit in accordance with the present invention.
**Figure 4** schematically shows a control signal generation circuit in accordance with the present invention.
**Figure 5** schematically shows a conventional NWELL (bias for PMOS transistors) generation block.
**Figure 6** is the graph of the DC sweep of the protection circuit according to the present invention.
**Figure 7** is the graph of the transient simulation of the circuit according to the present invention.

### Detailed Description:

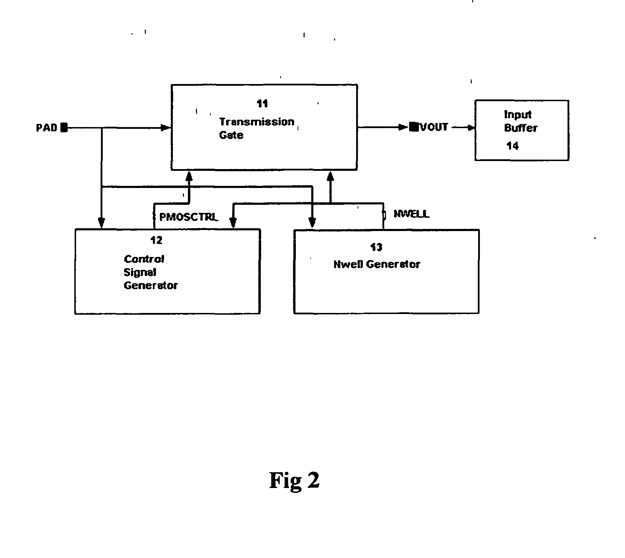

With reference to the drawings, and in particular to Figure 2, a block diagram of an improved voltage tolerant protection circuit for input buffer according to the present invention is shown.

The voltage tolerant protection circuit for input buffer comprises:
(i) a transmission gate circuit 11, for transferring a signal PAD from a pad to an input buffer 14,
(ii) a control signal generator 12, to generate a control signal PMOSCTRL for the transmission gate circuit 11, so as to enable the transmission gate circuit 11 to transfer a voltage VOUT from the pad to the input buffer 14, and
(iii) an NWELL generation circuit 13 to provide a bias voltage NWELL to the transmission gate circuit 11 and to the control signal generator 12, for minimizing power dissipation.

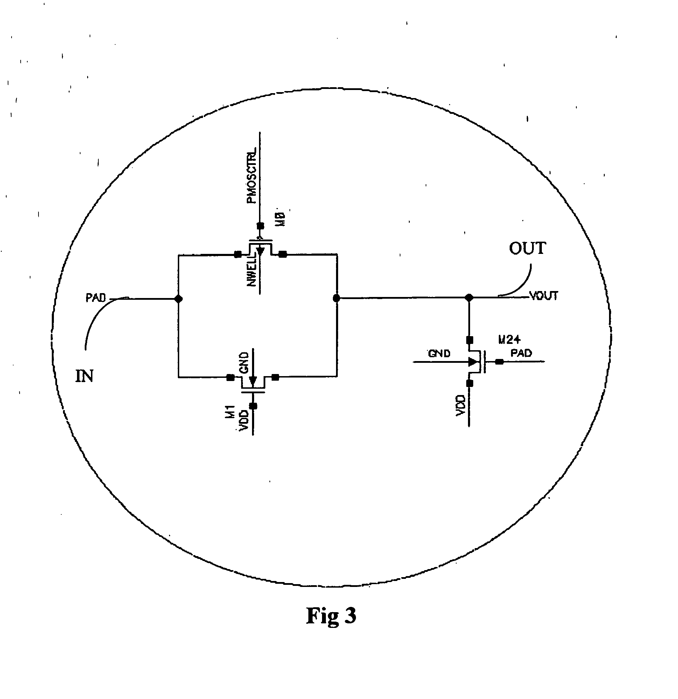

Figure 3 schematically shows the transmission gate circuit 11. Here, the PAD voltage is an input signal at an input terminal IN and the voltage VOUT is the output signal at an output terminal OUT of the transmission gate circuit 11. The voltage VOUT is the input signal also for the input buffer 14. The transmission gate circuit 11 is required to operate for the following input/ output parameters.
(i) When PAD voltage ≤VDD, VOUT=Pad voltage
(ii) When PAD voltage >VDD, VOUT≤VDD

For obtaining the above stated output parameters, the transmission gate circuit 11 comprises an NMOS M1 having a drain terminal connected to the input terminal IN, a source terminal connected to the output terminal OUT and a gate terminal connected to a supply voltage reference (VDD). As a result of this connection, the voltage VOUT follows the PAD voltage up to the threshold voltage value of the transistor M1 (VDD-Vtn).

The transmission gate circuit 11 further comprises a PMOS M0 required to shift the PAD voltage value from the NMOS threshold value to the supply voltage. To achieve this, the transistor M0 has a source terminal connected to the input terminal IN, a drain terminal connected to the output terminal OUT, and a gate terminal connected to the control signal generator 14 and receiving from it the signal PMOSCTRL. When the Pad voltage is less than or equal to the supply voltage VDD, the value of the PMOSCTRL signal is zero volt and the true value of the Pad voltage is transferred to VOUT, through the transistors NMOS M1 and PMOS M0. Further, the PMOSCTRL signal is equal to the Pad voltage when this Pad voltage is greater than the supply voltage. Consequently, the PMOS M0 is switched off to avoid to raise Pad voltage above the supply voltage. The transistor PMOS M0 also has a bulk or bias terminal connected to the NWELL generation block 13 and receiving from it a signal NWELL its. The signal NWELL is equal to the supply voltage when the Pad voltage is less than the supply voltage and the signal NWELL is equal to VPAD - Vt (Threshold Voltage) when the Pad voltage is higher than the supply voltage. When the Pad voltage is higher than the supply voltage, there should not be any risk of consumption from the input terminal IN to the bulk terminal of the transistor PMOS M0. Further, when the Pad voltage is higher than the supply voltage, the transistor PMOS M0 is switched off and only the transistor NMOS M1 is working. In this case a voltage value equal to VDD-Vtn (NMOS Threshold Voltage) appears as output voltage VOUT on the output terminal OUT, which is not the true supply voltage VDD and can thereby cause power consumption at the input buffer 14. To overcome these constraints and get a true value of the supply voltage on the output terminal OUT of the transmission gate circuit 11, it further comprises a transistor NMOS M24 having a drain terminal connected to the output terminal OUT, a source terminal connected to the supply voltage reference and a gate terminal connected to the input terminal IN, the Pad voltage being higher than the supply voltage. Whenever the Pad voltage is greater than VDD+Vtn (NMOS Threshold Voltage), the supply voltage is outputted at the output terminal OUT. Size of the transistor NMOS M24 is such that the voltage VOUT is equal to the supply voltage as soon as the PAD voltage crosses the supply voltage value VDD.

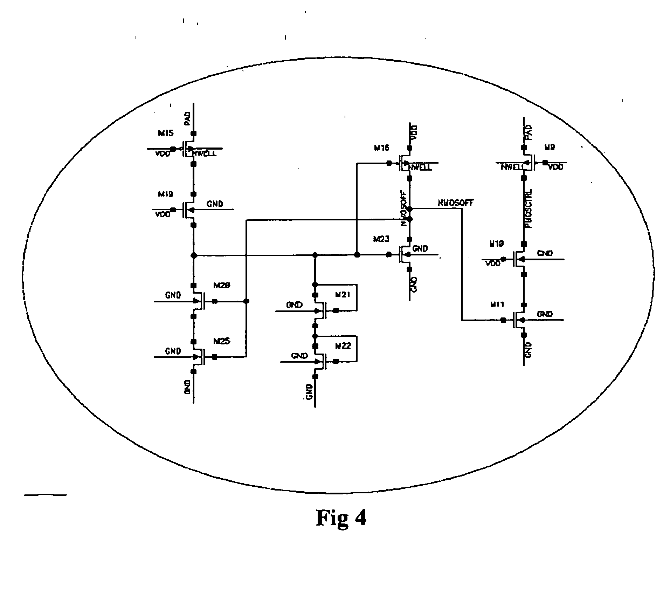

Figure 4 shows a circuit level diagram of the control signal generator 12 that receives as input signal at a PAD terminal the PAD voltage. The PMOSCTRL signal is generated from this block as a result. The control signal generator 12 is required to operate for the following input /output parameters.
(i) PMOSCTRL=0, when Pad voltage is less than or equal to VDD+Vt (PMOS Threshold Voltage).
(ii) PMOSCTRL=Pad Voltage, when Pad voltage is higher than VDD+Vt (PMOS Threshold Voltage), here the PMOSCTRL signal follows the Pad voltage.

For obtaining the above stated parameters, the control signal generator 12 comprises a PMOS M9 having a source terminal connected to a PAD terminal, a drain terminal receiving the PMOSCTRL signal, a gate terminal receiving to the supply voltage (VDD) and a bulk or bias terminal receiving the signal NWELL, to avoid power dissipation at the bulk of the transistor PMOS M9.

The control signal generator 12 also comprises a transistor NMOS M10, in series with the transistor PMOS M9, having a drain terminal receiving the PMOSCTRL signal, a source connected to a drain of a further transistor NMOS M11 and a gate terminal receiving the supply voltage VDD. As a result, stress on the transistors M10 and M11 is prevented when the PMOSCTRL signal follows the Pad voltage, and zero volt signal is transferred when Pad voltage is less than the supply voltage VDD. Thus, the drain of the transistor M11 does not exceed a voltage value equal to an NMOS Threshold voltage value and the drain to source voltage of the transistor M10 is equal to VPad -VDD, so that the transistors M10 and M11 are not stressed upto the Pad voltage.

The transistor NMOS M11 has a source terminal connected to ground GND, a drain terminal connected to the source terminal of the transistor NMOS M10 and a gate terminal receiving a signal NMOSOFF. The value of the NMOSOFF signal is equal to the supply voltage VDD when the Pad voltage is less than or equal to the supply voltage VDD and it is equal to zero when the Pad voltage is greater than the supply voltage VDD.

As per the above description, the three transistors M9, M10 and M11 operate for the following input/ output parameters:
(i) When the PAD voltage is less than or equal to VDD+Vt (PMOS Threshold voltage), then the value of the signal NMOSOFF is equal to the supply voltage VDD so that the transistor NMOS M11 transfers a zero volt value to the source terminal of the transistor M10. As the gate terminal of the transistor NMOS M10 is connected to the supply voltage reference VDD, it transfers a zero volt value to the PMOSCTRL signal. As a result the gate to source voltage of the transistor PMOS M9 has a positive value, hence the transistor PMOS M9 is switched off, thereby outputting a zero voltage value to the PMOSCTRL signal,
(ii) When the PAD voltage is greater than VDD+Vt (PMOS Threshold), a zero voltage value is outputted to the signal NMOSOFF, therefore the gate to source voltage of the transistor NMOS M11 is zero, thus the transistor NMOS M11 is switched off. As a result the gate to source voltage of the transistor PMOS M9 has a negative value and the Pad voltage is transferred to the PMOSCTRL signal, thus the PMOSCTRL signal follows the Pad voltage.

It is desirable to have the value of the NMOSOFF signal equal to the supply voltage VDD when the Pad voltage is less than or equal to the supply voltage VDD, and equal to zero when the Pad voltage is greater than the supply voltage VDD.

To achieve the above stated objective, the transistors PMOS M15 & M16, NMOS M19, M20, M21, M22, M23 & M25 are used. The transistor PMOS M15 has a source terminal connected to the PAD terminal, a gate terminal connected to the supply voltage reference VDD and a drain terminal connected to a drain terminal of the transistor NMOS M19. In this way, the transistor PMOS M15 is on when the pad voltage value is greater than VDD + Vt (PMOS Threshold voltage). So, the width of the transistor PMOS M15 should be kept high to transfer the Pad voltage to the drain terminal of the transistor PMOS M15 as soon as the pad voltage value crosses the supply voltage value VDD.

The transistor NMOS M19 has a gate terminal connected to the supply voltage reference VDD, a source terminal connected to drain terminals of the transistors NMOS M20 and NMOS M21 and to gate terminals of the transistors PMOS M16 and NMOS M23. The transistor NMOS M19 is used to avoid any stress on the transistors MOS M16, M20, M21, M22, M23 & M25. In any case, a voltage value of the source terminal of the transistor NMOS M19 does not exceed VDD-Vt (NMOS Threshold voltage).

The transistors NMOS M20 and M25 are connected in series. The transistor NMOS M20 has a drain terminal is connected to a source terminal of the transistor M19, a source terminal connected to the ground GND. The gate terminals of both the transistors NMOS M20 & M25 are connected to the signal NMOSOFF. The transistors NMOS M20 & M25 should be long channel transistors for obtaining a good switching at the drain terminal of the transistor NMOS M20. When the Pad voltage is higher than the supply voltage value VDD, a voltage of the gate terminals of the transistors M16 & M23 should be close to VDD-Vt (NMOS Threshold voltage), thus the current through these transistors M20 and M25 should be very low.

The transistors NMOS M21 and M22 have drain terminals connected to their gate terminals, wherein both the transistors operate like diodes. The transistor NMOS M21 has a source terminal connected to the drain terminal of the transistor NMOS M22, a source terminal of the transistor NMOS M22 being connected to ground GND. The transistors NMOS M21 and M22 are used to provide 2*Vt (NMOS Threshold voltage) to the gate terminal of the transistors M16 and M23, when the Pad voltage is less than or equal to the supply voltage VDD. The transistors NMOS M21 & M22 are long channel transistors for reducing power dissipation on the PAD terminal, the Pad voltage being greater than the supply voltage VDD.

The transistors PMOS M16 and NMOS M23 are connected together to form an inverter. Switching threshold for this inverter should be greater than 2*Vt (NMOS Threshold voltage) and less than VDD-Vt (NMOS Threshold) for obtaining the desired value of the NMOSOFF signal.

As per the above description of M15, M16, M20, M21, M22, M23 & M25, the circuit operates for the following input/output parameters.
(i) When the Pad voltage is less than or equal to VDD+Vt (PMOS Threshold voltage), Vgs (Gate to source voltage) of the transistor PMOS M15 has a positive value, consequently the transistor M15 is switched off. A potential value equal to 2*Vt (NMOS Threshold voltage) is established at the gate terminals of the transistors M16 and M23, due to the transistors NMOS M21 & M22. The switching threshold of the inverter formed by the transistors M16 and M23 causes the NMOSOFF signal approach towards the supply voltage value VDD, thereby causing the transistors NMOS M20 & M25 to be switched on, thus the potential at the gate terminals of the transistors M16 and M23 is equal to zero volt. Thereby, the NMOSOFF signal approaches true value of the supply voltage VDD.
(ii) When the PAD voltage is greater than VDD+Vt (PMOS Threshold voltage). Vgs of the transistor PMOS M15 has a negative value so that the the transistor PMOS M15 is switched on. As the gate terminal of the transistor NMOS M19 is connected to the supply voltage reference VDD, the gate terminals of M16 & M23 achieve a voltage level equal to VDD-Vt (NMOS Threshold voltage). As a result of the switching threshold of the inverter formed by the transistors M16 and M23, the NMOSOFF signal become ZERO and the transistors NMOS M20 & M25 are switched off.

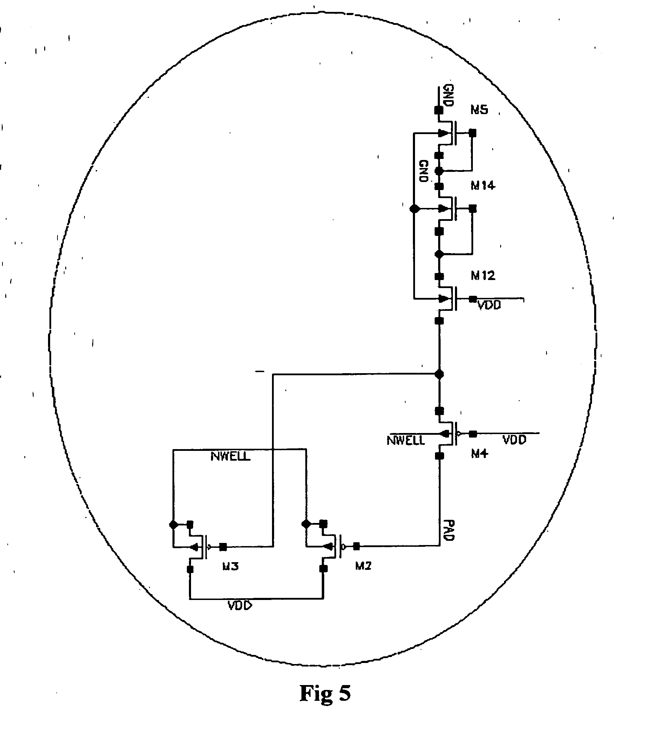

Figure 5 illustrates the circuit diagram of a conventional NWELL generator. PAD is a terminal receiving the Pad voltage as input signal for the NWELL generator, which generates bias signals NWELL for PMOS transistors in the protection circuit.

As described earlier, bias voltage for each PMOS transistors in the protection circuit is desirable equal to the supply voltage value VDD when the Pad voltage is less than the supply voltage VDD and equal to VPAD-Vt (Threshold voltage) when the Pad voltage is greater than the supply voltage VDD.

To achieve this, the NWELL generator comprises a transistor PMOS M2 having a source terminal connected to the supply voltage reference VDD, drain & bulk terminals connected to a NWELL terminal, and a gate terminal connected to a PAD terminal. The NWELL generator also comprises a transistor PMOS M4 having a source terminal connected to the PAD terminal, a gate terminal connected to the supply voltage reference VDD, a bulk terminal connected to the NWELL terminal and a drain terminal connected to a gate terminal of transistor PMOS M3 and to a drain terminal of a transistor NMOS M12. The transistor PMOS M3 has a source terminal connected to the supply voltage reference VDD, drain & bulk terminals connected to the NWELL terminal. The transistor NMOS M12 has a gate terminal connected to the supply voltage reference VDD, a source terminal connected to drain and gate terminals of a transistor NMOS M14. This transistor NMOS M12 is used to avoid stress on the transistors M14 and M5. The transistor NMOS M14 and M5 are drain-gate connected transistors for providing a voltage value equal to 2*Vt (NMOS Threshold voltage) on a gate terminal of a transistor PMOS M3 when the Pad voltage is less than VDD+Vt (PMOS Threshold voltage).

As per the above stated description, the transistors M2, M3, M4, M5, M12 & M14, operate to perform the following functions:
(i) When the Pad voltage is less than or equal to VDD+Vt (PMOS Threshold), Vgs of the transistor PMOS M4 is greater than the PMOS threshold value, thus the transistor PMOS M4 is switched off. Due to drain gate configuration of the transistors NMOS M14 and M5, the gate terminal of the transistor M3 has a voltage value equal to 2*Vt (NMOS Threshold voltage). As a result the gate voltage (Vg) of the transistor PMOS M3 is less than the threshold voltage, hence the supply voltage VDD is outputted to the NWELL terminal. For Pad voltage range 0 to VDD-Vt (PMOS Threshold voltage) the transistor PMOS M2 is switched on.
(ii) When the Pad voltage is greater than VDD+Vt (PMOS Threshold voltage), Vgs of the transistor PMOS M4 is less than the PMOS threshold value, thus the transistor PMOS M4 is switched on and the gate terminals of the transistors PMOS M3 and M2 are at same potential as on the PAD terminal, thereby resulting in switching off the transistors PMOS M2 and M3. As the source terminal of the transistor PMOS M4 is connected to the PAD terminal and its bulk terminal is connected to the NWELL terminal, there is one diode formed between source and bulk. If the source voltage is higher than the bulk voltage plus the threshold voltage, such diode conducts and the NWELL voltage become VPAD-Vt (Threshold voltage).

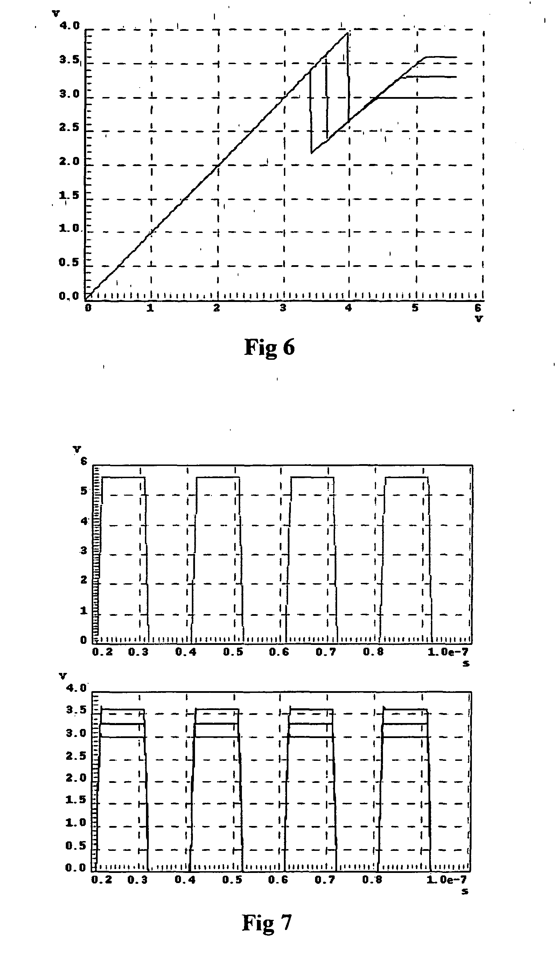

Figure 6 shows the effect of using a protection circuit for the Input buffer in dc- sweep. Here, X-Axis of this graph is the PAD voltage while the Y-Axis is the voltage to the Input Buffer. The protection circuit is simulated for three supply voltage levels 3.0V, 3.3V and 3.6V. As shown in the figure, the PAD voltage is varied from 0V to 5.6Volt. VOUT follows the PAD voltage up to VDD+Vt (PMOS Threshold, ~0.35V in this simulation), and the value of VOUT is either VDD-Vt (NMOS threshold) or VDD. Simulation results show that the Input buffer is protected from the higher PAD voltage and there can be full swing from 0V to supply voltage (VDD) at VOUT. Thus, it is concluded from the simulation results that attenuation free signal is obtained for the Input buffer.

Fig 7 shows the transient simulation results. Here, the circuit is simulated for the supply voltage levels of 3.0V, 3.3V and 3.6V. Pulse of amplitude 5.6V is applied on the PAD for generating a pulse of amplitude equal to supply voltage (VDD) at VOUT, thus providing the required voltage level to the Input Buffer.

## Claims

1. A voltage tolerant protection circuit for input buffer comprising:
- a transmission gate circuit (11) having an input terminal (IN) connected to a pad terminal for transferring a signal (PAD) from said pad terminal to an input buffer (14),
- a control signal generator (12) connected between said transmission gate circuit (11) and said pad terminal for providing a control signal (PMOSCTRL) for enabling said transmission gate circuit (11) to transfer a voltage (VOUT) from said pad terminal to said input buffer (14),
- an N-Well generation circuit (13) connected between said pad terminal and said transmission gate circuit (11), and also connected to said control signal generator (12) for generating a bias signal (NWELL) for said transmission gate circuit (11) and said control signal generator (12), said bias signal (NWELL) being equal to a supply voltage (VDD) if a pad voltage of said pad terminal is less than said supply voltage (VDD) and equal to the difference between said pad voltage of said pad terminal and a threshold voltage (Vt) of an NMOS transistor if said pad voltage is higher than said supply voltage (VDD) thus minimizing power dissipation,
- said control signal (PMOSCTRL) being equal to a ground voltage (GND) or zero volt if said pad voltage of said pad terminal is less than or equal to the sum of said supply voltage (VDD) and of a threshold voltage of a PMOS transistor and said control signal (PMOSCTRL) being equal to said pad voltage of said pad terminal if it is greater that said sum, and where said transmission gate circuit (11) comprises a first transistor (M24) having a first conduction terminal connected to an output terminal (OUT), a second conduction terminal connected to a supply voltage reference (VDD) and a control terminal connected to said pad terminal, said first transistor (M24) being driven by said signal (PAD) from said pad terminal for providing the value of said supply voltage (VDD) on said output terminal (OUT) if said pad voltage of said pad terminal is greater than the sum of said supply voltage (VDD) and of a threshold voltage of said first transistor (M24).

2. A voltage tolerant protection circuit as claimed in claim 1, wherein said transmission gate circuit (11) further comprises:
- a second transistor (M0) for receiving said control signal (PMOSCTRL) from said control signal generator (12) and said bias signal (NWELL) from said N-Well generation circuit (13) to transfer said signal (PAD) from said input terminal (IN) to said output terminal (OUT) if said control signal (PMOSCTRL) is zero volt ;
- a third transistor (M1) connected to said second transistor (M0) for receiving said supply voltage (VDD) and said ground voltage (GND) as control signals to form a closed path if said pad voltage is higher than said supply voltage (VDD);
- said first transistor (M24) being connected to said second and third transistors (M0, M1) at said output terminal (OUT).

3. A voltage tolerant protection circuit as claimed in claim 2, wherein said second transistor (M0) is a PMOS transistor and said first and third transistors (M24, M1) are NMOS transistors.

4. A voltage tolerant protection circuit as claimed in claim 1, wherein said control signal generator (12) comprises:
- a first PMOS transistor (M15) connected to said pad terminal for receiving said supply voltage (VDD) and said bias signal (NWELL) from said N-Well generation circuit (13) as control signals (VDD, NWELL),
said first PMOS transistor (M15) being on if said pad voltage is greater than the sum of said supply voltage (VDD) and of a threshold voltage of said first PMOS transistor (M15) thus avoiding consumption on said pad terminal;
- a second NMOS transistor (M19) connected in series to said first PMOS transistor (M15) and receiving said supply voltage (VDD) and said ground voltage (GND) as control signals (VDD, GND) so as to transfer a potential if said pad voltage is less than said supply voltage (VDD), a voltage value of a source terminal of said second NMOS transistor (M19) do not exceeding the difference between a supply voltage (VDD) and the threshold voltage of said second NMOS transistor (M19);
- a third NMOS transistor (M11) connected to a fourth NMOS transistor (M10) for receiving a first signal (NMOSOFF) and said ground voltage (GND) as control signals (NMOSOFF, GND) for transferring said ground voltage (GND) to a source terminal of said fourth NMOS transistor (M10) if said pad voltage is less than or equal to the sum of said supply voltage (VDD) and of a threshold voltage of said third NMOS transistor (M11) and to form an open circuit path if the pad voltage is greater than said sum;
- said fourth NMOS transistor (M10) connected to said third NMOS transistor (M11) for receiving said supply voltage (VDD) and said ground voltage (GND) as control signals (VDD, GND) for transferring said ground voltage (GND) to a source terminal of a fifth PMOS transistor (M9) connected to it if said pad voltage is less than or equal to the sum of said supply voltage (VDD) and of a threshold voltage of said NMOS transistor (M10);
- said fifth PMOS transistor (M9) connected to said pad terminal for receiving said bias signal (NWELL) and said supply voltage (VDD) as control signal (NWELL, VDD) for providing a closed path for conduction if said pad voltage is greater than the sum of said supply voltage (VDD) and of a threshold voltage of said PMOS transistor (M9);
- a sixth NMOS transistor (M20) connected to said second NMOS transistor (M19) having a control terminal connected to said third NMOS transistor (M11) for receiving said first signal (NMOSOFF) and a further control terminal for receiving said ground voltage (GND) for providing a controlled potential at a source terminal of said second NMOS transistor (M19);
- a seventh NMOS transistor (M25) connected in series to said sixth NMOS transistor (M20) and having a control terminal connected to said third NMOS transistor (M11) so as to receive said first signal (NMOSOFF) and a further control terminal for receiving said ground voltage (GND);
- an eighth NMOS transistor (M21) and a ninth NMOS transistor (M22) connected in series to each other and to said second NMOS transistor (M19) for outputting an NMOS threshold potential if said pad voltage is less than or equal to the supply voltage (VDD);
- a tenth PMOS transistor (M16) and an eleventh NMOS transistor (M23) connected in series to each other and connected from said supply voltage (VDD) to said ground voltage (GND) and having control terminals connected to said second NMOS transistor (M19), said tenth PMOS transistor (M16) having a further control terminal for receiving said bias signal (NWELL) and said eleventh NMOS transistor (M23) having a further control terminal receiving said ground voltage (GND) for providing said first signal (NMOSOFF) to said third NMOS transistor (M11), said first signal (NMOSOFF) being equal to said supply voltage (VDD) if said pad voltage is less than or equal to said supply voltage (VDD) and it is equal to zero when the pad voltage is greater than the supply voltage (VDD).

5. A voltage tolerant protection circuit as claimed in claim 4, wherein the drain terminals of said eighth and ninth NMOS transistors (M21, M22) are connected to their respective gate terminals.

6. A voltage tolerant protection circuit as claimed in claim 4, wherein said tenth PMOS transistor (M16) and said eleventh NMOS transistor (M23) are connected to each other to form an inverter circuit.

7. A method for protecting an input buffer circuit comprising steps of:
- transferring a signal (PAD) from a pad terminal to an input buffer (14) through a transmission gate circuit (11);
- providing a control signal (PMOSCTRL) to said transmission gate circuit (11) by a control signal generator (12), said control signal (PMOSCTRL) being equal to a ground voltage (GND) or zero volt when a pad voltage of said pad terminal is less than or equal to the sum of a supply voltage (VDD) and of a threshold voltage of a PMOS transistor, and being equal to said pad voltage when said pad voltage is greater than said sum, thereby avoiding electrical stress on the transistors comprised within said transmission gate circuit (11) and said control signal generator (12), said control signal (PMOSCTRL) enabling said transmission gate circuit (11) to transfer a voltage (VOUT) from said pad terminal to said input buffer (14); and
- providing a bias signal (NWELL) for said control signal generator (12) and transmission gate circuit (11), said bias signal (NWELL) being equal to the supply voltage (VDD) when said pad voltage is less than said supply voltage (VDD) and equal to the difference between said pad voltage of said pad terminal and a threshold voltage (Vt) when said pad voltage is greater than said supply voltage (VDD) thus minimizing power dissipation the value of said supply voltage reference (VDD) being provided on an output terminal (OUT) of said transmission gate circuit (11) by a first transistor (M24) when said signal (PAD) from said pad terminal is greater than the sum of said supply voltage (VDD) and of a threshold voltage of said first transistor (M24), said first transistor (M24) having a first conduction terminal connected to said output terminal (OUT), a second conduction terminal receiving said supply voltage (VDD) and a control terminal connected to said pad terminal.

## Patentansprüche

1. Spannungstoleranter Schutzschaltkreis für Eingangspuffer aufweisend:
- eine Übertragungsgatterschaltung (11) mit einem Eingangsanschluss (IN), der mit einem Kontaktstellen-Anschluss zum Übertragen eines Signals (PAD) an dem Kontaktstellen-Anschluss zu einem Eingangspuffer (14),
- ein Steuersignalgenerator (12), der zwischen die Übertragungsgatterschaltung (11) und den Kontaktstellen-Anschluss geschaltet ist, zum Bereitstellen eines Steuersignals (PMOSCTRL) zum Aktivieren der Übertragungsgatterschaltung (11), um eine Spannung (VOUT) von dem Kontaktstellen-Anschluss an den Eingangspuffer (14) zu übertragen,
- eine N-Quellen-Generatorschaltung (13), die zwischen den Kontaktstellenanschluss und die Übertragungsgatterschaltung (11) geschaltet ist, und außerdem mit dem Steuersignalgenerator (12) verschaltet ist, zum Erzeugen eines Vorspannungssignals (NWELL) für die Übertragungsgatterschaltung (11) und den Steuersignalgenerator (12), wobei das Vorspannungssignal (NWELL) gleich einer Versorgungsspannung (VDD) ist, wenn eine Kontaktstellenspannung des Kontaktstellenanschlusses kleiner als die Versorgungsspannung (VDD) ist, und gleich der Differenz zwischen der Kontaktstellenspannung des Kontaktstellenanschlusses und einer Schwellspannung (Vt) eines NMOS-Transistors ist, wenn die Kontaktstellenspannung größer als die Versorgungsspannung (VDD) ist, wobei es so Verlustleistung minimiert,
- das Steuersignal (PMOSCTRL), welches gleich einer Massespannung (GND) oder null Volt ist, wenn die Kontaktstellenspannung des Kontaktstellenanschlusses kleiner oder gleich der Summe der Versorgungsspannung (VDD) und einer Schwellspannung eines PMOS-Transistors ist und das Steuersignal (PMOSCTRL) gleich der Kontaktstellenspannung des Kontaktstellenanschlusses ist, wenn sie größer als die Summe ist,
und wobei die Übertragungsgatterschaltung (11) aufweist einen ersten Transistor (M24) mit einem ersten Leitungsanschluss, der mit einem Ausgangsanschluss (OUT) verschaltet ist, einem zweiten Leitungsanschluss, der mit einer Versorgungsspannungsreferenz (VDD) verschaltet ist, und einem Steueranschluss, der mit dem Kontaktstellenanschluss verschaltet ist, wobei der erste Transistor (M24) durch das Signal (PAD) von dem Kontaktstellenanschluss zum Bereitstellen des Wertes der Versorgungsspannung (VDD) an dem Ausgangsanschluss (OUT) getrieben wird, wenn die Kontaktstellenspannung des Kontaktstellenanschlusses größer als die Summe der Versorgungsspannung (VDD) und einer Schwellspannung des ersten Transistors (M24) ist.

2. Spannungstolerante Schutzschaltung gemäß Anspruch 1, wobei die Übertragungsgatterschaltung (11) weiter aufweist:
- einen zweiten Transistor (MO) zum Aufnehmen des Steuersignals (PMOSCTRL) von dem Steuersignalgenerator (12) und des Vorspannungssignals (NWELL) von der N-Quellen-Generatorschaltung (13), um das Signal (PAD) von dem Eingangsanschluss (IN) an den Ausgangsanschluss (OUT) zu übertragen, wenn das Steuersignal (PMOSCTRL) gleich null Volt ist.
- einen dritten Transistor (M1), der mit dem zweiten Transistor (M0) verschaltet ist, zum Aufnehmen der Versorgungsspannung (VDD) und der Massespannung (GND) als Steuersignale, um einen geschlossenen Weg zu bilden, wenn die Kontaktstellenspennung größer als die Versorgungsspannung (VDD) ist;
- den ersten Transistor (M24), der mit dem zweiten und dem dritten Transistor (M0, M1) an den Ausgangsanschluss (OUT) verschaltet ist.

3. Spannungstolerante Schutzschaltung gemäß Anspruch 2, wobei der zweite Transistor (M0) ein PMOS-Transistor ist und der erste und der dritte Transistor (M24, M1) NMOS-Transisitoren sind.

4. Spannungstolerante Schutzschaltung gemäß Anspruch 1, wobei der Steuersignalgenerator (12) aufweist:
- einen ersten PMOS-Transistor (M15), der mit dem Kontaktstellenanschluss verschaltet ist, zum Aufnehmen der Versorgungsspannung (VDD) und des Vorspannungssignals (NWELL) von der N-Quellen-Generatorschaltung (13) als Steuersignale (VDD, NWELL), wobei der erste PMOS-Transistor (M15) durchgeschaltet ist, wenn die Kontaktstellenspannung größer als die Summe der Versorgungsspannung (VDD) und einer Schwellspannung des ersten PMOS-Transistors (M15) ist, so einen Verbrauch an dem Kontaktstellenanschluss vermeidend;
- einen zweiten NMOS-Transistor (M19), der in Serie mit dem ersten PMOS-Transistor (M15) verschaltet ist, und die Versorgungsspannung (VDD) und die Massespannung (GND) als Steuersignale (VDD, GND) aufnimmt, um so ein Potential zu übertragen, wenn die Kontaktstellenspannung kleiner als die Versorgungsspannung (VDD) ist, wobei ein Spannungswert eines Source-Anschlusses des zweiten NMOS-Transistors (M19) nicht die Differenz zwischen einer Versorgungsspannung (VDD) und der Schwellspannung des zweiten NMOS-Transistors (M19) überschreitet;
- einen dritten NMOS-Transistor (M11), der mit einem vierten NMOS-Transistor (M10) verschaltet ist, zum Aufnehmen eines ersten Signals (NMOSOFF) und der Massespannung (GND) als Steuersignale (NMOSOFF, GND) zum Übertragen der Massespannung (GND) an einen Source-Anschluss des vierten NMOS-Transistors (M10), wenn die Kontaktstellenspannung kleiner oder gleich der Summe aus der Versorgungsspannung (VDD) und einer Schwellspannung des dritten NMOS-Transistors (M11) ist und um einen offenen Schaltungsweg auszubilden, wenn die Kontaktstellenspannung größer als die Summe ist;
- den vierten NMOS-Transistor (M10), der mit dem dritten NMOS-Transistor (M11) verschaltet ist, zum Aufnehmen der Versorgungsspannung (VDD) und der Massespannung (GND) als Steuersignale (VDD, GND) zum Übertragen der Massespannung (GND) an einen Source-Anschluss eines fünften PMOS-Transistors (M9), der mit ihm verschaltet ist, wenn die Kontaktellenspannung kleiner oder gleich der Summe aus der Versorgungsspannung (VDD) und einer Schwellspannung des NMOS-Transistors (M10) ist;
- den fünften PMOS-Transistors (M9), der mit dem Kontaktstellenanschluss verschaltet ist, zum Aufnehmen des Vorspannungssignals (NWELL) und der Versorgungsspannung (VDD) als Steuersignal (NWELL, VDD) zum Bereitstellen eines geschlossenen Leitungswegs, wenn die Kontaktstellenspannung größer als die Summe aus der Versorgungsspannung (VDD) und einer Schwellspannung des PMOS-Transistors (M9) ist;
- einen sechsten NMOS-Transistor (M20), der mit dem zweiten NMOS-Transistor (M19) verschaltet ist, mit einem Steueranschluss, der mit dem dritten NMOS-Transistor (M11), verschaltet ist, zum Aufnehmen des ersten Signals (NMOSOFF), und mit einem weiteren Steueranschluss zum Aufnehmen der Massespannung (GND) zum Bereitstellen eines gesteuerten Potentials an einem Source-Anschluss des zweiten NMOS-Transistors (M19) ;
- einen siebten NMOS-Transistor (M25), der in Serie mit dem sechsten NMOS-Transistor (M20) verschaltet ist, und mit einem Steuer-Anschluss, der mit dem dritten NMOS-Transistor (M11) verschaltet ist, um so das erste Signal (NMOSOFF) aufzunehmen, und mit einem weiteren Steueranschluss zum Empfangen der Massespannung (GND);
- einen achten NMOS-Transistor (M21) und einen neunten NMOS-Transistor (M22), die in Serie miteinander und mit dem zweiten NMOS-Transistor (M19) verschaltet sind, zum Ausgeben eines NMOS-Schwellpotentials, wenn die Kontaktstellenspannung kleiner oder gleich der Versorgungsspannung (VDD) ist;
- einen zehnten PMOS-Transistor (M16) und einen elften NMOS-Transistor (M23), die in Serie miteinander und von der Versorgungspannung (VDD) zu der Massespannung (GND) geschaltet sind und mit Steueranschlüssen, die mit dem zweiten NMOS-Transistor (M19) verschaltet sind, wobei der zehnte PMOS-Transistor (M16) einen weiteren Steuer-Anschluss aufweist zum Aufnehmen des Vorspannungssignals (NWELL) und der elfte NMOS-Transistor (M23) einen weiteren Steuer-Anschluss aufweist, welches die Massenspannung (GND) aufnimmt, zum Bereitstellen des ersten Signals (NMOSOFF) an den dritten NMOS-Transistor (M11), wobei das erste Signal (NMOSOFF) gleich der Versorgungsspannung (VDD) ist, wenn die Kontaktstellenspannung kleiner oder gleich der Versorgungsspannung (VDD) ist und gleich null ist, wenn die Kontaktstellenspannung größer als die Versorgungsspannung (VDD) ist.

5. Spannungstolerante Schutzschaltung gemäß Anspruch 4, wobei die Drain-Anschlüsse des elften und neuen NMOS-Transistors (M21, M22) mit ihren jeweiligen Gate-Anschlüssen verschaltet sind.

6. Spannungstolerante Schutzschaltung gemäß Anspruch 4, wobei der zehnte PMOS-Transistor (M16) und der elfte NMOS-Transistor (M23) miteinander verschaltet sind, um eine Inverter-Schaltung zu bilden.

7. Verfahren zum Schützen einer Eingangspufferschaltung, aufweisend die Schritte:
- Übertragen eines Signals (PAD) von einem Kontaktstellenanschluss an einen Eingangspuffer (14) durch eine Übertragungsgatterschaltung (11) ;
- Bereitstellen eines Steuersignals (PMOSCTRL) an der Übertragungsgatterschaltung (11) durch einen Steuersignalgenerator (12), wobei das Steuersignal (PMOSCTRL) gleich einer Massespannung (GND) oder null Volt ist, wenn eine Kontaktstellenspannung des Kontaktstellenanschlusses kleiner oder gleich der Summe einer Versorgungsspannung (VDD) und einer Schwellspannung eines PMOS-Transistors ist, und gleich der Kontaktstellenspannung ist, wenn die Kontaktstellenspannung größer als die Summe ist, dadurch vermeidend eine elektrische Überlastung der Transistoren, die in der Übertragungsgatterschaltung (11) und dem Steuersignal-Generator (12) enthalten sind, wobei das Steuersignal (PMOSCTRL) die Übertragungsgatterschaltung (11) aktiviert, um eine Spannung (VOUT) von dem Kontaktstellenanschluss an den Eingangspuffer (14) zu übertragen;
- Bereitstellen eines Vorspannungssignals (NWELL) für den Steuersignalgenerator (12) und die Übertragungsgatterschaltung (11), wobei das Vorspannungssignal (NWELL) gleich der Versorgungsspannung (VDD) ist, wenn die Kontaktstellenspannung kleiner als die Versorgungsspannung (VDD) ist, und gleich der Differenz zwischen der Kontaktstellenspannung des Kontaktstellenanschlusses und einer Schwellspannung (Vt) ist, wenn die Kontaktstellenspannung größer als die Versorgungsspannung (VDD) ist, so Verlustleistung minimierend,
wobei der Wert der Versorgungsspannungsreferenz (VDD) an einem Ausgangsanschluss (OUT) der Übertragungsgatterschaltung (11) durch einen ersten Transistor (M24) bereitgestellt wird, wenn das Signal (PAD) von dem Kontaktstellenanschluss größer als die Summe der Versorgungsspannung (VDD) und einer Schwellspannung des ersten Transistors (M24) ist, wobei der erste Transistor (M24) aufweist einen ersten Leitungsanschluss, der mit dem Ausgangsanschluss (OUT) verschaltet ist, einen zweiten Leitungsanschluss, der die Versorgungsspannung (VDD) aufnimmt und einen Steueranschluss, der mit dem Kontaktstellenanschluss verschaltet ist.

## Revendications

1. Circuit de protection tolérant aux tensions destiné à un tampon d'entrée, comprenant :
- un circuit formant porte de transmission (11) ayant une borne d'entrée (IN) connectée à une plage de contact pour transférer un signal (PAD) de ladite plage de contact à un tampon d'entrée (14),
- un générateur de signal de commande (12) connecté entre ledit circuit formant porte de transmission (11) et ladite plage de contact pour fournir un signal de commande (PMOSCTRL) permettant audit circuit formant porte de transmission (11) de transférer une tension (VOUT) de ladite plage de contact audit tampon d'entrée (14),
- un circuit générateur de puits de type N (13) connecté entre ladite plage de contact et ledit circuit formant porte de transmission (11), et également connecté audit générateur de signal de commande (12) pour générer un signal de polarisation (NWELL) pour ledit circuit formant porte de transmission (11) et ledit générateur de signal de commande (12), ledit signal de polarisation (NWELL) étant égal à une tension d'alimentation (VDD) si une tension de plage de ladite plage de contact est inférieure à ladite tension d'alimentation (VDD) et est égale à la différence entre ladite tension de plage de ladite plage de contact et une tension de seuil (Vt) d'un transistor NMOS si ladite tension de plage est supérieure à ladite tension d'alimentation (VDD) pour ainsi minimiser la dissipation d'énergie,
- ledit signal de commande (PMOSCTRL) étant égal à une tension de masse (GND) ou à zéro volt si ladite tension de plage de ladite plage de contact est inférieure ou égale à la somme de ladite tension d'alimentation (VDD) et d'une tension de seuil d'un transistor PMOS et ledit signal de commande (PMOSCTRL) étant égal à ladite tension de plage de ladite plage de contact si elle est supérieure à ladite somme,
et dans lequel ledit circuit formant porte de transmission (11) comprend un premier transistor (M24) ayant une première borne de conduction connectée à une borne de sortie (OUT), une deuxième borne de conduction connectée à une référence de tension d'alimentation (VDD) et une borne de commande connectée à ladite plage de contact, ledit premier transistor (M24) étant attaqué par ledit signal (PAD) provenant de ladite plage de contact pour fournir la valeur de ladite tension d'alimentation (VDD) sur ladite borne de sortie (OUT) si ladite tension de plage de ladite plage de contact est supérieure à la somme de ladite tension d'alimentation (VDD) et d'une tension de seuil dudit premier transistor (M24).

2. Circuit de protection tolérant aux tensions selon la revendication 1, dans lequel ledit circuit formant porte de transmission (11) comprend en outre :
- un deuxième transistor (MO) destiné à recevoir ledit signal de commande (PMOSCTRL) dudit générateur de signal de commande (12) et ledit signal de polarisation (NWELL) dudit circuit générateur de puits de type N (13) pour transférer ledit signal (PAD) de ladite borne d'entrée (IN) à ladite borne de sortie (OUT) si ledit signal de commande (PMOSCTRL) est à zéro volt ;
- un troisième transistor (M1) connecté audit deuxième transistor (M0) pour recevoir ladite tension d'alimentation (VDD) et ladite tension de masse (GND) en tant que signaux de commande afin de former un trajet fermé si ladite tension de plage est supérieure à ladite tension d'alimentation (VDD) ;
- ledit premier transistor (M24) étant connecté auxdits deuxième et troisième transistors (M0, M1) sur ladite borne de sortie (OUT).

3. Circuit de protection tolérant aux tensions selon la revendication 2, dans lequel ledit deuxième transistor (M0) est un transistor PMOS et lesdits
premier et troisième transistors (M24, M1) sont des transistors NMOS.

4. Circuit de protection tolérant aux tensions selon la revendication 1, dans lequel ledit générateur de signal de commande (12) comprend :
- un premier transistor PMOS (M15) connecté à ladite plage de contact pour recevoir ladite tension d'alimentation (VDD) et ledit signal de polarisation (NWELL) dudit circuit générateur de puits de type N (13) en tant que signaux de commande (VDD, NWELL), ledit premier transistor PMOS (M15) étant passant si ladite tension de plage est supérieure à la somme de ladite tension d'alimentation (VDD) et d'une tension de seuil dudit premier transistor PMOS (M15) pour ainsi éviter toute consommation sur ladite plage de contact ;
- un deuxième transistor NMOS (M19) connecté en série audit premier transistor PMOS (M15) et recevant ladite tension d'alimentation (VDD) et ladite tension de masse (GND) en tant que signaux de commande (VDD, GND) afin de transférer un potentiel si ladite tension de plage est inférieure à ladite tension d'alimentation (VDD), une valeur de tension d'une borne de source dudit deuxième transistor NMOS (M19) ne dépassant pas la différence entre une tension d'alimentation (VDD) et la tension de seuil dudit deuxième transistor NMOS (M19) ;
- un troisième transistor NMOS (M11) connecté à un quatrième transistor NMOS (M10) pour recevoir un premier signal (NMOSOFF) et ladite tension de masse (GND) en tant que signaux de commande (NMOSOFF, GND) pour transférer laite tension de masse (GND) à une borne de source dudit quatrième transistor NMOS (M10) si ladite tension de plage est inférieure ou égale à la somme de ladite tension d'alimentation (VDD) et d'une tension de seuil dudit troisième transistor NMOS (M11) et pour former un trajet de circuit ouvert si la tension de plage est supérieure à ladite somme ;
- ledit quatrième transistor NMOS (M10) connecté audit troisième transistor NMOS (M11) pour recevoir ladite tension d'alimentation (VDD) et ladite tension de masse (GND) en tant que signaux de commande (VDD, GND) pour transférer ladite tension de masse (GND) à une borne de source d'un cinquième transistor PMOS (M9) qui lui est connecté si ladite tension de plage est inférieure ou égale à la somme de ladite tension d'alimentation (VDD) et d'une tension de seuil dudit transistor NMOS (M10) ;
- ledit cinquième transistor PMOS (M9) connecté à ladite plage de connexion pour recevoir ledit signal de polarisation (NWELL) et ladite tension d'alimentation (VDD) en tant que signaux de commande (NWELL, VDD) pour former un trajet de conduction fermé si ladite tension de plage est supérieure à la somme de ladite tension d'alimentation (VDD) et d'une tension de seuil dudit transistor PMOS (M9) ;
- un sixième transistor NMOS (M20) connecté audit deuxième transistor NMOS (M19) ayant une borne de commande connectée audit troisième transistor NMOS (M11) pour recevoir ledit premier signal (NMOSOFF) et une autre borne de commande pour recevoir ladite tension de masse (GND) afin de fournir un potentiel commandé sur une borne de source dudit deuxième transistor NMOS (M19) ;
- un septième transistor NMOS (M25) connecté en série audit sixième transistor NMOS (M20) et ayant une borne de commande connectée audit troisième transistor NMOS (M11) de manière à recevoir ledit premier signal (NMSOFF) et une autre borne de commande pour recevoir ladite tension de masse (GND) ;
- un huitième transistor NMOS (M21) et un neuvième transistor NMOS (M22) connectés l'un à l'autre en série et audit deuxième transistor NMOS (M19) pour fournir en sortie un potentiel de seuil NMOS si ladite tension de plage est inférieure ou égale à la tension d'alimentation (VDD) ;
- un dixième transistor PMOS (M16) et un onzième transistor NMOS (M23) connectés l'un à l'autre en série et connectés de ladite tension d'alimentation (VDD) à ladite tension de masse (GND) et ayant des bornes de commande connectées audit deuxième transistor NMOS (M19), ledit dixième transistor PMOS (M16) ayant une autre borne de commande pour recevoir ledit signal de polarisation (NWELL) et ledit onzième transistor NMOS (M23) ayant une autre borne de commande recevant ladite tension de masse (GND) pour fournir ledit premier signal (NMOSOFF) audit troisième transistor NMOS (M11), ledit premier signal (NMOSOFF) étant égal à ladite tension d'alimentation (VDD) si ladite tension de plage est inférieure ou égale à ladite tension d'alimentation (VDD) et étant égale à zéro lorsque ladite tension de plage est supérieure à la tension d'alimentation (VDD).

5. Circuit de protection tolérant aux tensions selon la revendication 4, dans lequel les bornes de drain desdits huitième et neuvième transistors NMOS (M21, M22) sont connectées à leurs bornes de grille respectives.

6. Circuit de protection tolérant aux tensions selon la revendication 4, dans lequel ledit dixième transistor PMOS (M16) et ledit onzième transistor NMOS (M23) sont connectés l'un à l'autre pour former un circuit inverseur.

7. Procédé de protection d'un circuit de tampon d'entrée comprenant les étapes consistant à :
- transférer un signal (PAD) d'une plage de contact à un tampon d'entrée (14) par l'intermédiaire d'un circuit formant porte de transmission (11) ;
- fournir un signal de commande (FMOSCTRL) audit circuit formant porte de transmission (11) à partir d'un générateur de signal de commande (12), ledit signal de commande (PMOSCTRL) étant égal à une tension de masse (GND) ou à zéro volt lorsqu'une tension de plage de ladite plage de contact est inférieure ou égale à la somme d'une tension d'alimentation (VDD) et d'une tension de seuil d'un transistor PMOS, et étant égal à ladite tension de plage lorsque ladite tension de plage est supérieure à ladite somme, pour ainsi éviter de soumettre à une contrainte électrique les transistors que comprennent ledit circuit formant porte de transmission (11) et ledit générateur de signal de commande (12), ledit signal de commande (PMOSCTRL) permettant audit circuit formant porte de transmission (11) de transférer une tension (VOUT) de ladite plage de contact audit tampon d'entrée (14) ; et
- fournir un signal de polarisation (NWELL) destiné audit générateur de signal de commande (12) et audit circuit formant porte de transmission (11), ledit signal de polarisation (NWELL) étant égal à la tension d'alimentation (VDD) lorsque ladite tension de plage est inférieure à ladite tension d'alimentation (VDD) et étant égal à la différence entre ladite tension de plage de ladite plage de contact et une tension de seuil (Vt) lorsque ladite tension de plage est supérieure à ladite tension d'alimentation (VDD) pour ainsi minimiser la dissipation d'énergie,
la valeur de ladite référence de tension d'alimentation (VDD) étant fournie sur une borne de sortie (OUT) dudit circuit formant porte de transmission (11) par un premier transistor (M24) lorsque ledit signal (PAD) provenant de ladite plage de contact est supérieur à la somme de ladite tension d'alimentation (VDD) et d'une tension de seuil dudit premier transistor (M24), ledit premier transistor (M24) ayant une première borne de conduction connectée à ladite borne de sortie (OUT), une deuxième borne de conduction recevant ladite tension d'alimentation (VDD) et une borne de commande connectée à ladite plage de contact.
